# EUROPÄISCHE PATENTSCHRIFT

(11) **EP 3 226 018 B1**
(45) Veröffentlichungstag und Bekanntmachung des Hinweises auf die Patenterteilung: **07.11.2018**
(21) Anmeldenummer: 16163269.0
(22) Anmeldetag: 31.03.2016
(51) Int. Cl.: G01R 33/09

(54) **DETEKTION EINES ÖFFNUNGSVORGANGES EINER ABDECKVORRICHTUNG**
DETECTION OF AN OPENING PROCESS OF A COVERING DEVICE
DETECTION D'UN PROCESSUS D'OUVERTURE D'UN DISPOSITIF DE RECOUVREMENT

(43) Veröffentlichungstag der Anmeldung: 04.10.2017
(73) Patentinhaber: Siemens Aktiengesellschaft, 80333 München (DE)
(72) Erfinder: Oechsle, Walter, 90766 Fürth (DE); Stecher, Werner, 91183 Abenberg (DE); Wolf, Stefan, 91074 Herzogenaurach (DE)

(56) Entgegenhaltungen:
- WO-A2-2007/124129
- US-A1- 2008 054 895

## Beschreibung

Detektion eines Öffnungsvorganges einer Abdeckvorrichtung Die Erfindung betrifft eine Vorrichtung zur Detektion eines Öffnungsvorganges einer Abdeckvorrichtung, wobei die Abdeckvorrichtung zum Abdecken einer Öffnung eines Gehäuses ausgebildet ist und wobei das Gehäuse zur Aufnahme der Vorrichtung und eines elektrischen Geräts ausgebildet ist. Des Weiteren betrifft die Erfindung ein elektrisches Gerät, das zur Aufnahme im Gehäuse ausgebildet ist.

Eine derartige Vorrichtung kann zum Schutz von sensiblen elektrischen Geräten vor Manipulationen eingesetzt werden. Dies ist beispielsweise bei sicheren Arbeitsplatzrechnern oder weiteren Computern der Fall, ist aber ebenso in weiteren Gebieten wie bei Bankautomaten oder Empfängern für verschlüsselte Signale, insbesondere verschlüsselte Satellitensignale, anwendbar.

Aus WO 2007/124129 A2 ist eine manipulationsfeststellende Gehäuseanordnung für einen umschlossenen Raum, die einen Innenraum enthält, in dem ein geschütztes Objekt positioniert ist, bekannt. Dabei kommt ein magnetoresistiver Magnetspeicher zum Einsatz, der gegenüber einem extern anliegenden Magnetfeld empfindlich ist. Der Magnetspeicher verändert seinen magnetischen Zustand messbar, wenn in das Gehäuse eingedrungen wurde.

Eine ähnliche Vorrichtung ist auch aus der US2008054895 bekannt. Die Aufgabe der vorliegenden Erfindung ist es, eine Vorrichtung der eingangs genannten Art zur Vertügung zu stellen, die eine zuverlässige Erkennung eines Öffnungsvorgangs auch von Gehäusen mit einem im Verhältnis zu deren Außenmaßen großen inneren Volumen ermöglicht.

Die Aufgabe wird durch eine Vorrichtung mit den im Anspruch 1 angegebenen Merkmalen gelöst. Dabei weist die Vorrichtung mindestens eine Magnetanordnung und mindestens eine Magnetfeldsensoranordnung auf. Die Magnetanordnung weist mindestens einen Permanentmagnet und die Magnetfeldsensoranordnung weist mindestens einen Magnetfeldsensor auf. Die Magnetanordnung erstreckt sich derart entlang der relevanten Gehäusedimension, dass sich ein Öffnungsvorgang in einer Magnetfeldänderung im Erfassungsbereich der Magnetfeldsensoranordnung auswirkt.

Die Abdeckvorrichtung kann dabei eine Abdeckung, ein Deckel, eine Klappe eines Gehäuses oder einfach ein Teil eines zweigeteilten Gehäuses sein, die jeweils zusammen ein geschlossene Einheit ergeben. Jegliche weitere Kombinationen die zusammen eine geschlossene Einheit ergeben sind ebenfalls denkbar. Die Abdeckvorrichtung und das Gehäuse sind zumindest teilweise voneinander trennbar ausgeführt.

Die Öffnung kann dabei z.B. die Öffnung des Gehäuses sein, die durch Entfernen der Abdeckvorrichtung entsteht. Das Gehäuse ist ein Gehäuse, das zur Aufnahme eines elektrischen Gerätes ausgebildet ist und mit der Abdeckvorrichtung verschließbar ist. Die Vorrichtung soll nun jegliche Öffnungsvorgänge der Abdeckvorrichtung gegenüber dem Gehäuse detektieren können.

Die relevante Gehäusedimension soll dabei die Dimension eines Gehäuses mit dem geforderten Volumeninhalt sein, die von der Magnetanordnung zu überbrücken ist, um den Öffnungsvorgang der Abdeckvorrichtung detektieren zu können. Dazu wird eine entsprechende Magnetfeldänderung im Erfassungsbereich der Magnetfeldsensoranordnung ausgelöst. Beispielsweise kann die relevante Gehäusedimension die Höhe eines Gehäuses sein. Jede weitere Dimension von Gehäusen mit den unterschiedlichsten Formen ist ebenso denkbar, abhängig davon wo die Abdeckvorrichtung angebracht ist und in welche Richtung sie entfernt wird. Die Magnetanordnung und/oder die Magnetfeldsensoranordnung sind jeweils derart an der Abdeckvorrichtung und/oder dem Gehäuse angebracht, dass der Öffnungsvorgang in einer Magnetfeldänderung im Erfassungsbereich der Magnetfeldsensoranordnung auswirkt. Der Erfassungsbereich der Magnetfeldsensoranordnung soll dabei der Bereich sein, in dem sich das Magnetfeld der Magnetanordnung durch einen Übergang vom geschlossenen Zustand des Gehäuses in einen geöffneten Zustand des Gehäuses verändert und die Magnetfeldsensoranordnung diese Änderung erfassen kann.

Die Magnetanordnung kann dabei beispielsweise an der Abdeckvorrichtung angebracht sein. Wenn die Magnetanordnung aus einzelnen Magneten besteht, so können sich diese an verschiedenen Orten der Abdeckvorrichtung befinden. Auch das Anordnen von mehreren Magnetanordnungen ist denkbar. Die Magnetfeldsensoranordnung erfasst in geschlossenem Zustand beispielsweise das Magnetfeld der Magnetanordnung und kann damit feststellen, dass das Gehäuse ordnungsgemäß geschlossen ist. Die Magnetfeldsensoranordnung kann dabei aus mehreren Magnetfeldsensoren bestehen, wobei die Magnetfeldsensoren beispielsweise als GMR-Sensoren ausgebildet sein können. Je mehr Permanentmagnete die Magnetanordnung aufweist, desto mehr Kombinationsmöglichkeiten ergeben sich um eine einzigartige Magnetanordnung zu konstruieren. Die Abdeckvorrichtung sowie das Gehäuse können dabei beispielsweise aus Aluminium, insbesondere aus Duraluminium, bestehen das eine vernachlässigbare magnetische Beeinflussung aufweist. Mit der vorliegenden Erfindung ist es also vorteilhaft möglich, auch bei Gehäusen mit einem ausgeprägten Volumen, Zugriffe auf das Gehäuse zuverlässig zu erkennen und weitere Schritte als Reaktion auf den Zugriff durchzuführen. Diese Schritte können vom Dokumentieren selbst bis hin zu einer Zerstörung des elektrischen Gerätes oder dessen Daten reichen.

In einer vorteilhaften Ausführungsform weist die relevante Gehäusedimension mindestens ein Verhältnis von 1:10, insbesondere 1:5 oder 1:2, zu mindestens einer weiteren Gehäusedimension auf. Das Verhältnis soll dabei zum Ausdruck bringen, dass es sich um ein Gehäuse handelt, welches ein entsprechendes Volumen umschließt und dadurch die Abdeckvorrichtung einen von der Magnetanordnung zu überbrückenden Abstand von der Magnetsensoranordnung und von den Bauteilen des elektrischen Geräts aufweist. Sind die Permanentmagnete der Magnetanordnung beispielsweise an der Abdeckvorrichtung befestigt, so ist es für eine zuverlässige Erkennung eines Öffnungsvorganges nötig, dass die Magnetfeldänderung im Erfassungsbereich der Magnetfeldsensoranordnung ausreichend stark ausgeprägt ist. Es ist ebenso denkbar, dass konstruktive Gegebenheiten des elektrischen Geräts und des Gehäuses dazu führen, dass eine Vorrichtung zur vorteilhaft zur Anwendung kommen kann. Dies kann beispielsweise dann der Fall sein, wenn es konstruktiv notwendig ist die relevante Dimension zu überbrücken auch wenn das Gehäuse für sich genommen eine derartige Vorrichtung nicht benötigen würde. In Verbindung mit dem elektrischen Gerät kann aber eine Vorrichtung deutliche Vorteile mit sich bringen.

In einer weiteren Ausführungsform erstreckt sich die Magnetanordnung mindestens über ein Drittel, insbesondere mindestens über die Hälfte der relevanten Gehäusedimension.

Diese Ausführungsform ist besonders bei Gehäusen von Vorteil, die ein im Verhältnis zu ihren Außenmaßen großes inneres Volumen aufweisen. Derartige Gehäuse können beispielsweise einen nahezu würfelförmiges Gehäuse sein, da diese im Verhältnis zur Oberfläche und den Außenmaßen ein sehr großes Volumen aufweisen. Ebenso quasi quaderförmige Gehäuse die eine gewisse Höhe aufweisen wären hier zu nennen. Analog gilt dies auch für Gehäuse deren inneres Volumen derart bemessen ist, dass ein Überbrücken des Abstandes zwischen der Abdeckvorrichtung und den Magnetfeldsensoren notwendig ist. Erstreckt sich nun die Magnetanordnung in einem solchen Gehäuse über mindestens ein Drittel, insbesondere mindestens über die Hälfte der relevanten Gehäusedimension, so kann auch bei solchen Gehäusen mit einem großen Volumen sichergestellt werden, dass eine Öffnung der Abdeckvorrichtung sich in einer ausreichend starken und damit detektierbaren Änderungen des Magnetfelds im Erfassungsbereich der Magnetfeldsensoranordnung auswirkt.

In einer weiteren Ausführungsform weist die Vorrichtung eine Magnetfeldführungsanordnung auf, die zur Führung des Magnetfeldes der Magnetanordnung in einen Erfassungsbereich der Magnetsensoranordnung im geschlossenen Zustand der Abdeckvorrichtung ausgebildet. Je nach verwendetem Sensortyp sind hier entsprechende Toleranzen zulässig. Der Erfassungsbereich sollte dabei idealerweise so groß sein, dass die durch die Fertigung und Montage auftretenden Toleranzen kompensiert werden können, sollte aber andererseits so klein sein, dass eine Manipulation durch von außen angelegte Magnetfelder nicht möglich ist. Die Magnetfeldführungsanordnung erhöht die konstruktive Freiheit bei der Konstruktion des Gehäuses. Ziel der Magnetfeldführungsanordnung ist es, das Magnetfeld der Magnetanordnung bzw. der einzelnen Permanentmagnete im geschlossenen Zustand des Gehäuses so an die Magnetfeldsensoranordnung heranzuführen, dass erstens eine Manipulation von außen nur erschwert möglich ist und zweitens auch die konstruktive Freiheit im Inneren des Gehäuses, insbesondere bezüglich der Positionierung der Magnetfeldsensoren, erhöht wird. Die Magnetfeldführungsanordnung besteht aus einem weichmagnetischen Werkstoff, d.h. ferromagnetische Materialien mit hoher magnetischer Permeabilität und geringer Remanenz.

In einer weiteren Ausführungsform ist die Magnetfeldführungsanordnung derart ausgebildet, dass sie einen Großteil des Abstands zwischen der Abdeckvorrichtung und der Magnetsensoranordnung überbrückt. Dies ist insbesondere in großen Gehäusen von Vorteil. Ein Großteil kann dabei beispielsweise über die Hälfte der zu überbrückenden Gehäusedimension, wie beispielsweise die Gehäusehöhe, sein. Auf diese Art wird sichergestellt, dass die Abdeckvorrichtung auch bei entsprechend hohem Platzbedarf innerhalb des Gehäuses mit der Vorrichtung gesichert werden kann. Der hohe Platzbedarf ist nicht notwendigerweise auf ein besonders großes elektrisches Gerät zurückzuführen, sondern kann auch viele weitere Gründe haben. Hier wären beispielsweise vorgegebene Abstände des elektrischen Geräts von den Gehäusewänden, die Abschirmung von elektromagnetischer Strahlung von außerhalb des Gehäuses (Sicherheit gegenüber Beeinflussung von außen) und/oder von innerhalb des Gehäuses (Abhörsicherheit) oder die Dämpfung von mechanischen Einflüssen auf den Inhalt des Gehäuses zu nennen. In diesen und weiteren Fällen ist es vorteilhaft entsprechende Magnetfeldführungsanordnungen, die einen Großteil des Abstands zwischen der Magnetanordnung und der Magnetsensoranordnung überbrücken, vorzusehen. Beispielsweise können die Magnetfeldführungsanordnungen über 60%, insbesondere über 80% des Abstandes überbrücken.

In einer weiteren Ausführungsform ist der Magnetfeldsensor zur Erfassung der Richtung von Magnetfeldern ausgebildet. Ist der Magnetfeldsensor nicht nur zur Erfassung einer Magnetfeldstärke sondern auch zur Erfassung der Richtung von Magnetfeldern ausgebildet, so kann die Vorrichtung auch erkennen, ob die Magnetanordnungen, z.B. an der Abdeckvorrichtung, an den richtigen Stellen angebracht sind, sondern kann auch erkennen, ob die Magnete auch die richtige Ausrichtung ihrer Pole aufweisen. Besonders vorteilhaft ist daran, dass so nicht nur die Stärke des Magnetfelds sondern auch die Richtung des Magnetfelds ausgewertet werden kann und so eine höhere Sicherheit gewährleistet werden kann.

In einer weiteren Ausführungsform ist die Magnetanordnung als ein Teil der Abdeckvorrichtung ausgebildet. Die Abdeckvorrichtung kann bereits bei der Konstruktion so ausgebildet werden, dass die Magnetanordnung ein Teil der Abdeckvorrichtung ist. Dabei ist zu beachten, dass die Abdeckvorrichtung, die Magnetanordnung und die Magnetfeldführungsanordnung aus verschiedenen Materialien bestehen können.

In einer weiteren Ausführungsform ist die Magnetfeldführungsanordnung als ein Befestigungsmittel ausgebildet, wobei das Befestigungsmittel zur Befestigung der Abdeckvorrichtung am Gehäuse vorgesehen ist. Die Befestigungsmittel können dabei Nieten, Bolzen, Schrauben, Nägel oder weitere derartige Befestigungsmittel sein, die mit dem Verschließen des Gehäuses durch die Abdeckvorrichtung das Magnetfeld der Magnetanordnung an die Magnetfeldsensoranordnung weiterleiten. So kann gewährleistet werden, dass das Gehäuse, sobald es einmal ordnungsgemäß montiert wurde, nicht wieder geöffnet werden kann, ohne das Magnetfeld der Magnetanordnung zu beeinflussen. Sollte versucht werden, eines der Befestigungsmittel zu entfernen, also beispielsweise eine Schraube herauszudrehen, so wird dies direkt vom zugeordneten Magnetfeldsensor der zugeordneten Magnetfeldsensoranordnung erkannt und entsprechende Maßnahmen können getroffen werden. Diese Maßnahmen können dabei beispielsweise ein Sperren des elektrischen Geräts oder das Deaktivieren einzelner Funktionen sein.

In einer weiteren Ausführungsform sind die Befestigungsmittel derart ausgebildet, dass sie von außerhalb des Gehäuses nicht lösbar, insbesondere nicht zerstörungsfrei lösbar, sind. Dies hat den Vorteil, dass der Eindringschutz noch weiter verbessert wird. Beispielsweise können die Befestigungsmittel als Nieten, eingepresste Bolzen oder jegliche weitere Befestigungsmittel die beispielsweise verschweißt oder verlötet werden ausgebildet sein. Sollte nun eines der Befestigungsmittel durch herausgebohrt werden, so verändert sich sofort das an der Magnetfeldsensoranordnung anliegende Magnetfeld und der Versuch des Eindringens wird erkannt.

In einer weiteren Ausführungsform weist die Magnetfeldsensoranordnung eine Schnittstelle zum elektrischen Gerät auf. Es ist denkbar, dass die Schnittstelle zum elektrischen Gerät dabei sowohl Daten als auch elektrische Leistung übertragen kann. Sind am elektrischen Gerät mehrere Anschlüsse für solche Schnittstellen der Magnetfeldsensoranordnung vorgesehen und sind diese so ausgebildet, dass die Magnetsensoranordnung bei der Montage einfach ausgetauscht werden kann, so ist es denkbar, dass für jede Magnetanordnung auch eigens eine Magnetfeldsensoranordnung bereitgestellt wird. Diese eigens bereitgestellten Magnetfeldsensoranordnungen können dann jeweils auf die genaue Art und Weise der Anbringung der Magnetanordnung abgestimmt werden. Dies ermöglicht eine enorm flexible Produktion einer solchen Vorrichtung, und erhöht die Sicherheit durch Trennung der Produktion der sicherheitsrelevanten Bauteile vom restlichen Gerät weiter.

In einer weiteren Ausführungsform ist die Magnetfeldsensoranordnung ein Teil des elektrischen Geräts. Es ist denkbar, dass die Magnetfeldsensoranordnung als ein Teil des elektrischen Geräts ausgebildet ist und dort bereits bei der Konstruktion berücksichtigt wird. Dies ist zwar weniger flexibel, kann aber bei einer potentiellen Massenproduktion deutlich günstiger gefertigt werden. Auch hier kann eine interne Schnittstelle den Datentransfer sicherstellen und elektrische Leistung zur Verfügung stellen.

In einer weiteren Ausführungsform weist die Magnetfeldsensoranordnung eine Auswerteeinheit auf, die zur Generierung eines Freischalt- und/oder Sperrsignals zur Freischaltung und/oder Sperrung von Funktionen des elektrischen Geräts ausgebildet ist. Die Auswerteeinheit kann dabei ein kleiner Mikrocontroller oder eine analoge Logik sein. Jegliche weitere Auswerteeinheiten, wie beispielsweise ein ASIC oder ein FPGA sind ebenso denkbar. Die Aufgabe der Auswerteeinheit ist es, die Signale der Magnetfeldsensoranordnung und damit der einzelnen Magnetfeldsensoren so auszuwerten, dass daraus auf den Zustand der Abdeckvorrichtung des Gehäuses geschlossen werden kann. Stellt die Auswerteeinheit nun fest, dass das Gehäuse ordnungsgemäß mit der Abdeckvorrichtung verschlossen ist, so kann ein Freischalt- und/oder ein Sperrsignal an das elektrische Gerät ausgegeben werden. Dabei können erweiterte Funktionen des Geräts freigeschaltet werden oder auch, falls ein eingeschränkter Betrieb des elektrischen Geräts ohne die Abdeckvorrichtung möglich ist, Funktionen deaktiviert werden. Analog können ebenfalls, wenn die Abdeckvorrichtung nicht ordnungsgemäß angebracht ist, entsprechende erweiterte Funktionen gesperrt werden.

Die Aufgabe wird weiterhin gelöst durch ein elektrisches Gerät, das zur Aufnahme in einem Gehäuse ausgebildet ist, und ferner eine Schnittstelle zu einer Vorrichtung aufweist. Als ein elektrisches Gerät kann dabei jegliches elektrische Gerät in Frage kommen, das vorteilhaft in einem geschützten Gehäuse betrieben werden soll. Dies können beispielsweise sichere PCs, Empfänger von verschlüsselten Signalen, Bankautomaten und viele weitere Geräte sein. Die Schnittstelle des elektrischen Geräts ist dabei so ausgebildet, dass sie mit einer Magnetfeldsensoranordnung und evtl. mit einer der Auswerteeinheiten kommunizieren kann.

Weiterhin kann die Magnetfeldsensoranordnung zur Erfassung einer charakteristischen Magnetisierung der Magnetanordnung ausgebildet sein. Die charakteristische Magnetsierung soll dabei durch die Anordnung der einzelnen Permanentmagneten hervorgerufene Muster der magnetischen Feldstärke und -richtung sein, die durch die Magnetsensoranordnung erfasst und im Anschluss ausgewertet werden kann. Anhand der charakteristischen Magnetsierung kann also festgestellt werden, ob sich die richtige Abdeckvorrichtung auf dem Gehäuse befindet. Weiterhin könnte die Magnetfeldsensoranordnung eine Auswerteeinheit aufweisen, die zur Auswertung der charakteristischen Magnetisierung und zur Weitergabe der charakteristischen Magnetisierung oder einer darauf basierenden Information an das elektrische Gerät über die Schnittstelle ausgebildet ist. Die charakteristische Magnetisierung kann also an das elektrische Gerät weitergegeben werden, um dort weiterverarbeitet zu werden. Die Schnittstelle kann dabei als sichere Schnittstelle mit einer verschlüsselten Übertragung ausgebildet sein, es können aber ebenso die Messwerte der Magnetfeldsensoren direkt übertragen werden. Je nach Ausprägung muss die Magnetfeldsensoranordnung entsprechende Auswerteelektronik aufweisen. Bei einer verschlüsselten Kommunikation ist es denkbar, dass sowohl das elektrische Gerät als auch die Magnetfeldsensoranordnung einen Kryptochip aufweisen, der eine verschlüsselte Verbindung ermöglicht.

Weiterhin kann das elektrische Gerät eine Auswerteeinheit aufweisen, die zur Auswertung einer charakteristischen Magnetisierung und/oder eine auf der charakteristischen Magnetisierung basierenden weiteren Information ausgebildet ist. Werden über die Schnittstelle des elektrischen Geräts und die Schnittstelle der Magnetfeldsensoranordnung die Rohdaten der Magnetfeldsensoren übertragen, so ist es denkbar, dass das elektrische Gerät selbst eine Auswerteeinheit aufweist. Die Auswerteeinheit wertet die Sensorsignale aus und darauf basierend können weitere Aktionen durchgeführt werden. Bei einer Integration einer Auswerteeinheit in oder auf das elektrische Gerät ist denkbar, dass die Auswerteeinheit lediglich ein logischer Bestandteil einer im elektrischen Gerät vorhandenen CPU ist. Werden die Sensorsignale bereits als eine ausgewertete charakteristische Magnetisierung weitergegeben, so können diese ebenfalls in der Auswerteeinheit des elektrischen Geräts ausgewertet werden. Ebenso denkbar ist, dass die Auswerteeinheit des elektrischen Geräts zur Freischaltung und/oder Sperrung von Funktionen des elektrischen Geräts ausgebildet ist. Die Auswerteeinheit des elektrischen Geräts kann also beispielsweise so ausgebildet sein, dass bei Abwesenheit der Abdeckvorrichtung entsprechende Funktionen des elektrischen Geräts gesperrt werden. Analog können bei Anwesenheit der Abdeckvorrichtung entsprechende Funktionen des elektrischen Geräts freigeschaltet werden. Auch hier gilt, dass die Auswerteeinheit in eine vorhandene CPU integriert sein kann.

Im Folgenden wird die Erfindung anhand der in den Figuren dargestellten Ausführungsbeispiele näher beschrieben und erläutert. Es zeigen:
- FIG 1: ein Gehäuse mit einer Abdeckvorrichtung und einer Vorrichtung zur Detektion eines Öffnungsvorganges,
- FIG 2: eine Ausführungsform einer Magnetanordnung,
- FIG 3: eine weitere Ausführungsform einer Magnetanordnung und
- FIG 4: ein Gehäuse mit einer Abdeckvorrichtung und einer Vorrichtung zur Detektion eines Öffnungsvorganges, wobei die Magnetanordnung Befestigungsmittel als Magnetfeldführungsanordnung aufweist.

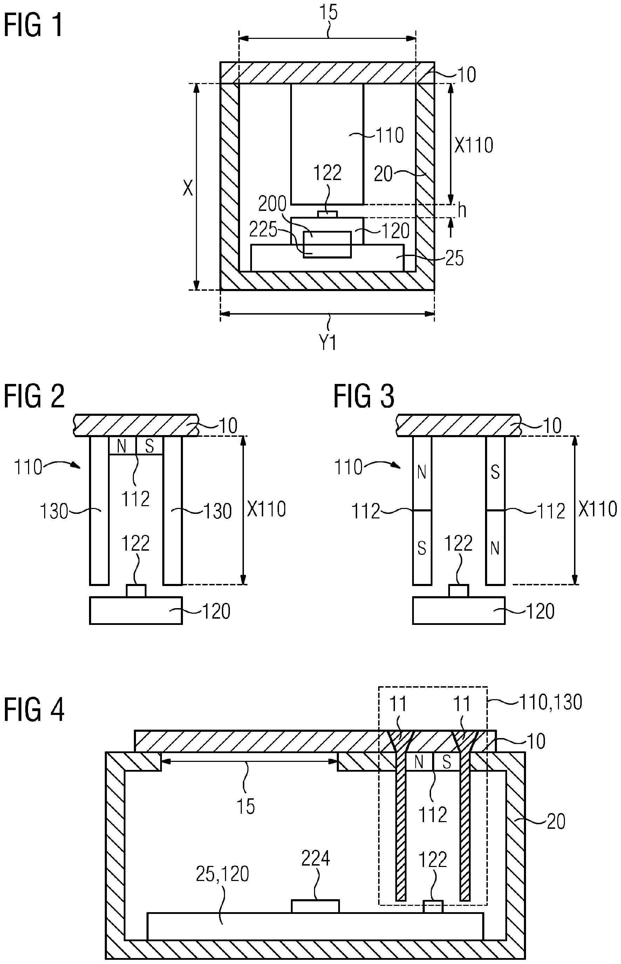

FIG 1 zeigt eine Ausführungsform einer Vorrichtung zur Detektion eines Öffnungsvorganges einer Abdeckvorrichtung 10 in einem Gehäuse 20, das eine Öffnung 15 aufweist und mit der Abdeckvorrichtung 10 verschlossen ist. Im Gehäuse 20 befindet sich ein elektrisches Gerät 25 mit einer Schnittstelle 225. Die Vorrichtung weist eine Magnetanordnung 110 und eine Magnetfeldsensoranordnung 120 auf. Die Magnetfeldsensoranordnung 120 ist dabei zur Erfassung eines Öffnungsvorgangs der Abdeckvorrichtung 10 ausgebildet, die sich in einer Magnetfeldänderung im Erfassungsbereich der Magnetfeldsensoranordnung 120 auswirkt. Das Gehäuse 20 weist eine relevante Gehäusedimension X und eine weitere Gehäusedimension Y1 auf. Die relevante Gehäusedimension X ist hier die Höhe des Gehäuses 20, da die Abdeckvorrichtung 10 das Gehäuse 20 von oberhalb verschließt und sich dementsprechend die Magnetanordnung 110 entlang der relevanten Gehäusedimension X erstreckt um eine Magnetfeldänderung durch den Öffnungsvorgang hervorzurufen. Die weitere Gehäusedimension Y1 ist hier die Breite des Gehäuses 20 und das Verhältnis X:Y1 der relevanten Gehäusedimension X zur weiteren Gehäusedimension Y1 ist in diesem Fall größer als 1:2, was zu einer erheblichen Strecke entlang der relevanten Gehäusedimension X führt, die von der Magnetanordnung 110 überbrückt wird. Die Magnetanordnung 110 erstreckt sich in dieser Ausführungsform vorteilhaft über mindestens ein Drittel, insbesondere über mindestens die Hälfte der relevanten Gehäusedimension X. Die Erstreckung X110 der Magnetanordnung 110 ist dabei die Dimension der Magnetanordnung 110, die sich entlang der relevanten Gehäusedimension X erstreckt. Hier ist klar zu erkennen, dass diese Ausführungsform besonders gut geeignet ist, um das Öffnen von Gehäusen 20 zu detektieren, die im Verhältnis zu ihren Außenmaßen großes inneres Volumen aufweisen. Ein Abstand h zwischen der Magnetfeldsensoranordnung 120 und der Magnetanordnung 110 stellt dabei sicher, dass trotz Fertigungs- und Montagetoleranzen im geschlossenen Zustand des Gehäuses 20 keine Beschädigungen der Magnetfeldsensoranordnung 120 oder des elektrischen Geräts 25 eintreten und trotzdem das Magnetfeld der Magnetanordnung 110 in den Erfassungsbereich des Magnetfeldsensors 122 geführt wird. Das elektrische Gerät 25 ist dabei nur schematisch dargestellt. Die Schnittstelle 225 des elektrischen Geräts 25 ist dabei so ausgebildet, dass sie mit der Schnittstelle 200 der Magnetfeldsensoranordnung 120 kommunizieren kann. Dabei kann es sich um einfache Steckverbindungen handeln, es können dabei aber auch Schnittstellen, wie USB, optische oder Netzwerkschnittstellen verwendet werden. Ausführungsformen der Magnetanordnung 110 werden in den FIG 2 und 3 näher erläutert.

FIG 2 zeigt einen Ausschnitt einer Abdeckvorrichtung 10. Eine Magnetanordnung 110 mit einer Erstreckung X110 umfasst dabei einen Permanentmagnet 112 und Magnetfeldführungsanordnungen 130. Die Magnetanordnung 110 ist an der Abdeckvorrichtung 10 angeordnet. Schematisch ist weiterhin eine Magnetfeldsensoranordnung 120 zu erkennen, die einen Magnetfeldsensor 122 aufweist. Die Magnetfeldführungsanordnungen 130 führen das Magnetfeld des Permanentmagnets 112 jeweils zur Magnetfeldsensoranordnung 120 und damit in den Erfassungsbereich des Magnetfeldsensors 122. Die beiden Magnetfeldführungsanordnungen 130 sind dabei idealerweise aus einem weichmagnetischen Werkstoff gefertigt, d.h. ein ferromagnetisches Material mit hoher magnetischer Permeabilität und geringer Remanenz. Es handelt sich also um sogenannte magnetische Leiter. Auf diese Weise ist sichergestellt, dass das Magnetfeld des Permanentmagnets 112 entsprechend in den Erfassungsbereich des Magnetfeldsensors 122 und damit der Magnetfeldsensoranordnung 120 weitergeleitet wird. Zur Führung des Magnetfeldes des Permanentmagnets 112 können die Magnetfeldführungsanordnungen 130 beispielsweise wie dargestellt jeweils einen Schenkel pro Pol N, S des Permanentmagnets 112 aufweisen. Die Magnetfeldführungsanordnung 130 kann dabei am Gehäuse 20 oder an der Abdeckvorrichtung 10 befestigt sein. Für die Funktion der Vorrichtung ist es lediglich relevant, dass bei einem Entfernen der Abdeckvorrichtung 10 eine Änderung des Magnetfelds im Erfassungsbereich der Magnetfeldsensoranordnung 120 erfolgt. Dies kann dadurch geschehen, dass die Magnetfeldführungsanordnungen 130 mit der Abdeckvorrichtung 10 entfernt werden und damit das Magnetfeld nicht mehr weitergeleitet wird. Alternativ können auch nur die Magnete 112 mit der Abdeckvorrichtung 10 entfernt werden. Auch eine Ausführungsform, in der sowohl die Magnetanordnungen 110 als auch die Magnetfeldführungsanordnungen 130 ein Teil der Abdeckvorrichtung 10 ausgebildet sind, ist denkbar. Der Permanentmagnet 112 kann in die Magnetfeldführungsanordnung 130 integriert sein oder davon getrennt befestigt sein.

FIG 3 zeigt eine alternative Ausführungsform zu der in FIG 2 gezeigten Magnetanordnung 110. Der Ausschnitt der Abdeckvorrichtung 10 ist hier mit zwei Permanentmagneten 112 versehen. Die Permanentmagnete 112 sind dabei derart angeordnet und gestaltet, dass ihr Magnetfeld durch ihre schenkelförmige Anordnung ohne weitere Magnetfeldführungsanordnungen 130 an den Magnetfeldsensor 122 der Magnetfeldsensoranordnung 120 geleitet wird. In diesem Fall sind die Permanentmagnete 112 an der Abdeckvorrichtung 10 befestigt. Ein Entfernen der Abdeckvorrichtung 10 entfernt somit auch die Permanentmagnete 112 und deren Magnetfeld aus dem Erfassungsbereich der Magnetfeldsensoranordnung 120.

FIG 4 zeigt ein Gehäuse 20 unter Beibehaltung der Bezugszeichen aus FIG 1. Dabei weist die Magnetanordnung 110 eine Magnetfeldführungsanordnung 130 und einen Permanentmagnet 112 auf. Die Magnetfeldführungsanordnung 130 ist in dieser Ausführungsform als zwei Befestigungsmittel 11 ausgebildet. Die Befestigungsmittel 11 leiten das Magnetfeld des Permanentmagnets 112 an den Magnetfeldsensor 122 weiter und sind dabei idealerweise aus einem weichmagnetischen Werkstoff gefertigt, d.h. ein ferromagnetisches Material mit hoher magnetischer Permeabilität und geringer Remanenz. Sollte nun eines der Befestigungsmittel 11 entfernt werden, so ändert sich das Magnetfeld im Erfassungsbereich der Magnetfeldsensoranordnung 120 und ein Eindringen in das Gehäuse kann erkannt werden. Die Befestigungsmittel 11 können dabei so ausgestaltet sein, dass sie nach einmaligen befestigen nicht mehr gelöst werden können. Dies kann beispielsweise durch Einpressen von Stiften geschehen. Des Weiteren ist zu sehen, dass die Magnetfeldsensoranordnung 120 und das elektrische Gerät 25 als eine Einheit ausgebildet sind. Dies ist eine Ausgestaltung der Vorrichtung, die es bei begrenztem Platz oder bei einer geforderten höheren Integrationsdichte ermöglicht, die Magnetfeldsensoranordnung 120 und das elektrische Gerät 25 zu vereinen. Für die Auswertung der Signale des Magnetsensoranordnung 120 und der Magnetsensors 122 weist das elektrische Gerät 25 eine Auswerteeinheit 224 auf. Die Schnittstellen, die hier nicht gezeigt sind, können bspw. als interne Schnittstellen ausgeführt sein.

Zusammenfassend betrifft die Erfindung eine Vorrichtung zur Detektion eines Öffnungsvorganges einer Abdeckvorrichtung 10, wobei die Abdeckvorrichtung 10 zum Abdecken einer Öffnung 15 eines Gehäuses 20 ausgebildet ist und wobei das Gehäuse 20 zur Aufnahme der Vorrichtung und eines elektrischen Geräts 25 ausgebildet ist. Des Weiteren betrifft die Erfindung ein elektrisches Gerät 25, das zur Aufnahme im Gehäuse 20 ausgebildet ist. Um eine Vorrichtung der eingangs genannten Art zur Verfügung zu stellen, die eine zuverlässige Erkennung eines Öffnungsvorgangs auch von Gehäusen 20 mit einem im Verhältnis zu deren Außenmaßen großen inneren Volumen ermöglicht, wird vorgeschlagen dass die Vorrichtung mindestens eine Magnetanordnung 110 und mindestens eine Magnetfeldsensoranordnung 120 aufweist, wobei die Magnetanordnung 110 mindestens einen Permanentmagnet 112 aufweist, wobei die Magnetfeldsensoranordnung 120 mindestens einen Magnetfeldsensor 122 aufweist und wobei sich die Magnetanordnung 110 derart entlang einer relevanten Gehäusedimension X erstreckt, dass sich ein Öffnungsvorgang in einer Magnetfeldänderung im Erfassungsbereich der Magnetfeldsensoranordnung 120 auswirkt.

## Patentansprüche

1. Vorrichtung zur Detektion eines Öffnungsvorganges einer Abdeckvorrichtung (10), wobei die Abdeckvorrichtung (10) zum Abdecken einer Öffnung (15) eines Gehäuses (20) ausgebildet ist und wobei das Gehäuse (20) zur Aufnahme der Vorrichtung und eines elektrischen Geräts (25) ausgebildet ist,
**dadurch gekennzeichnet, dass**
die Vorrichtung mindestens eine Magnetanordnung (110) und mindestens eine Magnetfeldsensoranordnung (120) aufweist, wobei die Magnetanordnung (110) mindestens einen Permanentmagnet (112) mit einem Magnetfeld aufweist, wobei die Magnetfeldsensoranordnung (120) mindestens einen Magnetfeldsensor (122) aufweist,
wobei sich die Magnetanordnung (110) derart entlang einer relevanten Gehäusedimension (X) erstreckt, dass sich ein Öffnungsvorgang in einer Magnetfeldänderung im Erfassungsbereich der Magnetfeldsensoranordnung (120) auswirkt,
wobei die Magnetanordnung (120) mindestens eine Magnetfeldführungsanordnung (130) aufweist, die im geschlossenen Zustand der Abdeckvorrichtung (10) zur Führung des Magnetfeldes der Magnetanordnung (110) in einen Erfassungsbereich der Magnetsensoranordnung (120) ausgebildet ist und wobei die Magnetfeldführungsanordnung aus einem weichmagnetischen Werkstoff gefertigt ist.

2. Vorrichtung nach Anspruch 1, wobei die relevante Gehäusedimension (X) mindestens ein Verhältnis von 1:10, insbesondere 1:5 oder 1:2, zu mindestens einer weiteren Gehäusedimension (Y1) aufweist.

3. Vorrichtung nach Anspruch 1 oder 2, wobei sich die Vorrichtung nach Anspruch 1 oder 2, wobei sich die Magnetanordnung (110) mindestens über ein Drittel, insbesondere mindestens über die Hälfte der relevanten Gehäusedimension (X) erstreckt.

4. Vorrichtung nach einem der vorhergehenden Ansprüche, wobei der Magnetfeldsensor (122) zur Erfassung der Richtung von Magnetfeldern ausgebildet ist.

5. Vorrichtung nach einem der vorhergehenden Ansprüche, wobei die Magnetanordnung (120) als ein Teil der Abdeckvorrichtung (10) ausgebildet ist.

6. Vorrichtung nach Anspruch 1, Anspruch 4 oder Anspruch 5, wobei die Magnetfeldführungsanordnung (130) als ein oder mehrere Befestigungsmittel (11) ausgebildet ist, wobei das Befestigungsmittel (11) zur Befestigung der Abdeckvorrichtung (10) am Gehäuse (20) vorgesehen ist.

7. Vorrichtung nach Anspruch 6, wobei die Befestigungsmittel (11) derart ausgebildet sind, dass sie von außerhalb des Gehäuses (20) nicht lösbar, insbesondere nicht zerstörungsfrei lösbar, sind.

8. Vorrichtung nach einem der vorhergehenden Ansprüche, wobei die Magnetfeldsensoranordnung (120) eine Schnittstelle (200) zum elektrischen Gerät (25) aufweist.

9. Vorrichtung nach einem der vorhergehenden Ansprüche, wobei die Magnetfeldsensoranordnung (120) ein Teil des elektrischen Geräts (25) ist.

10. Vorrichtung nach einem der vorhergehenden Ansprüche, wobei die Magnetfeldsensoranordnung (120) eine Auswerteeinheit (124) aufweist, die zur Generierung eines Freischalt- und/oder Sperrsignals zur Freischaltung und/oder Sperrung von Funktionen des elektrischen Geräts (25) ausgebildet ist.

11. Elektrisches Gerät (25) ausgebildet zur Aufnahme in einem Gehäuse (20) aufweisend eine Schnittstelle (225) zu einer Vorrichtung nach einem der vorhergehenden Ansprüche.

## Claims

1. Device for detecting an opening process of a covering device (10), wherein the covering device (10) is embodied to cover an opening (15) of a housing (20) and wherein the housing (20) is embodied to accommodate the device and an electrical apparatus (25),
**characterised in that**
the device has at least one magnet arrangement (110) and at least one magnetic field sensor arrangement (120), wherein the magnet arrangement (110) has at least one permanent magnet (112) with a magnetic field, wherein the magnetic field sensor arrangement (120) has at least one magnetic field sensor (122),
wherein the magnet arrangement (110) extends along a relevant housing dimension (X) such that with a change in magnetic field an opening process has an impact in the detection region of the magnetic field sensor arrangement (120),
wherein the magnet arrangement (120) has a least one magnetic field guiding arrangement (130), which in the closed state of the covering device (10) is embodied for guiding the magnetic field of the magnet arrangement (110) into a detection region of the magnetic field sensor arrangement (120) and wherein the magnetic field guiding arrangement is manufactured from a soft-magnetic material.

2. Device according to claim 1, wherein the relevant housing dimension (X) has at least a ratio of 1:10, in particular 1:5 or 1:2, with respect to at least one further housing dimension (Y1).

3. Device according to claim 1 or 2, wherein the device according to claim 1 or 2, wherein the magnet arrangement (110) extends at least beyond a third, in particular at least beyond the half of the relevant housing dimension (X).

4. Device according to one of the preceding claims, wherein the magnetic field sensor (122) is embodied to detect the direction of magnetic fields.

5. Device according to one of the preceding claims, wherein the magnet arrangement (120) is embodied as part of the covering device (10).

6. Device according to claim 1, claim 4 or claim 5, wherein the magnetic field guiding arrangement (130) is embodied as one or more fastening means (11), wherein the fastening means (11) is provided to fasten the covering device (10) to the housing (20).

7. Device according to claim 6, wherein the fastening means (11) are embodied such that they cannot be detached, in particular cannot be nondestructively detached, from outside of the housing (20).

8. Device according to one of the preceding claims, wherein the magnetic field sensor arrangement (120) has an interface (200) with the electrical apparatus (25).

9. Device according to one of the preceding claims, wherein the magnetic field sensor arrangement (120) is part of the electrical apparatus (25).

10. Device according to one of the preceding claims, wherein the magnetic field sensor arrangement (120) has an evaluation unit (124), which is embodied to generate an activation and/or blocking signal for activating and/or blocking functions of the electrical apparatus (25).

11. Electrical apparatus (25) embodied for accommodation in a housing (20) having an interface (225) with a device according to one of the preceding claims.

## Revendications

1. Dispositif de détection d'une opération d'ouverture d'un dispositif (10) de recouvrement, le dispositif (10) de recouvrement étant constitué pour recouvrir une ouverture (15) d'un boîtier (20) et le boîtier (20) étant constitué pour recevoir le dispositif et un appareil (25) électrique,
**caractérisé en ce que**
le dispositif a un système (110) d'aimant et au moins un système (120) de capteur de champ magnétique,
dans lequel le système (110) d'aimant a au moins un aimant (112) permanent ayant un champ magnétique, le système (120) de capteur de champ magnétique ayant au moins un capteur (122) de champ magnétique,
le dispositif (110) d'aimant s'étendant suivant une dimension (X) pertinente du boîtier, de manière à ce qu'une opération d'ouverture se traduise par une variation du champ magnétique dans le domaine de détection du système (120) de capteur de champ magnétique,
dans lequel le système (120) d'aimant a au moins un système (130) de guidage de champ magnétique, qui, lorsque le dispositif (10) de recouvrement est à l'état fermé, est constitué pour guider le champ magnétique du système (110) d'aimant dans un domaine de détection du système (120) de capteur magnétique et dans lequel le système de guidage de champ magnétique est en un matériau à magnétisme doux.

2. Dispositif suivant la revendication 1, dans lequel la dimension (X) pertinente du boîtier a au moins un rapport de 1:10, notamment de 1:5 ou 1:2, à au moins une autre dimension (Y1) du boîtier.

3. Dispositif suivant la revendication 1 ou 2, dans lequel le système (110) d'aimant s'étend au moins sur un tiers, notamment au moins sur la moitié de la dimension (X) pertinente du boîtier.

4. Dispositif suivant l'une des revendications précédentes, dans lequel le capteur (122) de champ magnétique est constitué pour la détection de la direction de champ magnétique.

5. Dispositif suivant l'une des revendications précédentes, dans lequel le système (120) d'aimant est constitué comme partie du dispositif (10) de recouvrement.

6. Dispositif suivant la revendication 1, la revendication 4 ou la revendication 5, dans lequel le système (130) de guidage de champ magnétique est constitué sous la forme d'un ou de plusieurs moyens (11) de fixation, le moyen (11) de fixation étant prévu pour la fixation du dispositif (10) de recouvrement au boîtier (20).

7. Dispositif suivant la revendication 6, dans lequel les moyens (11) de fixation sont constitués de manière à ne pas pouvoir être défaits, notamment sans destruction, de l'extérieur du boîtier (20).

8. Dispositif suivant l'une des revendications précédentes, dans lequel le système (120) de capteur de champ magnétique a une interface (200) avec l'appareil (25) électrique.

9. Dispositif suivant l'une des revendications précédentes, dans lequel le système (120) de capteur de champ magnétique fait partie de l'appareil (25) électrique.

10. Dispositif suivant l'une des revendications précédentes, dans lequel le système (120) de capteur de champ magnétique a une unité (124) d'exploitation, qui est constituée pour la production d'un signal de libération et/ou d'un signal de blocage pour libérer et/ou bloquer des fonctions de l'appareil (25) électrique.

11. Appareil (25) électrique constitué pour être reçu dans un boîtier (20) comportant une interface (225) avec un dispositif suivant l'une des revendications précédentes.
